(19) **Europäisches Patentamt / European Patent Office / Office européen des brevets**

(11) **EP 1 585 223 B1**

(12) **EUROPEAN PATENT SPECIFICATION**

(45) Date of publication and mention
of the grant of the patent:
**03.10.2007 Bulletin 2007/40**

(51) Int Cl.:
*H03L 1/00* *(2006.01)* *H04B 1/16* *(2006.01)*

(21) Application number: **05252080.6**

(22) Date of filing: **01.04.2005**

(54) **Method and circuit for determining a slow clock calibration factor**

Verfahren und Anordnung zur Bestimmung eines Kalibrations-Faktors für einen langsamen Takt

Méthode et circuit pour déterminer un facteur de calibration pour une horloge lente

(84) Designated Contracting States:
**DE FR GB**

(30) Priority: **06.04.2004 US 819056**

(43) Date of publication of application:
**12.10.2005 Bulletin 2005/41**

(73) Proprietor: **Integration Associates Inc.**
**Mountain View, CA 94041 (US)**

(72) Inventors:
• **Erdélyi, Jànos**
**2120, Dunakeszi (HU)**

• **Onody, Péter**
**11, Budapest 1101 (HU)**

(74) Representative: **Wilson, Alan Stuart**
**Barker Brettell,**
**138 Hagley Road Edgbaston**
**Birmingham B16 9PW (GB)**

(56) References cited:
**WO-A-01/97383** **US-A- 6 029 061**
**US-B1- 6 326 825**

## Description

## FIELD OF THE INVENTION

The invention relates to a method and circuit for determining a calibration parameter, where the calibration parameter is used to compensate for the variations of a low accuracy clock signal compared to a high accuracy clock signal.

## BACKGROUND OF THE INVENTION

Various electronic devices require a more or less exact and reliable clock signal. Such clock signals are typically generated by various types of oscillators, which deliver an alternating current (AC) signal on a fixed or tunable frequency. There are certain applications which require an accurate reference frequency. Particularly, wireless devices need accurate reference clock signals to generate a precise radio frequency (RF) local oscillator frequency and for maintaining an exact time base so that they are able to transmit between the transmitter and the receiver at precise time intervals.

Moreover, an increasing number of wireless devices are designed to be operated by battery. These devices may be required to operate for a relatively long time, in some instances for at least a year. Examples of such devices are radio transmitters and receivers built into an external sensor and an indoor monitoring station, such as thermometer-weather station. In order to increase battery life, such devices are designed for reduced power consumption. The power consumption is sought to be reduced by sending the data from the transmitter at certain periods only. An exact time base is necessary for the synchronous time-keeping between the sender and the receiver, so that both units switch on and off simultaneously, and may communicate with each other in predetermined time slots. For example, if the duration of the active transmission time is negligible compared with the duration of the idle times between the time slots, the exact timing of these time slots can bring substantial savings in the duration of the transmission, which directly translates into longer battery life.

It is known in the art that high frequency crystal oscillators are generally much more accurate than resistor capacitor (RC) oscillators, and in most wireless devices, a high frequency crystal oscillator is present anyway, mostly for the purposes of the RF transmission. However, high frequency crystal oscillators have higher power consumption, even during those time periods when the device is actually not transmitting or receiving. Therefore, it has been proposed to install a slower clock signal source having a lower consumption, and to turn off the high frequency oscillators during idle periods, using the slow clock signal for reference purposes. It would be possible to use another crystal oscillator as a slow clock, but it is desired to avoid another crystal in the circuit. Instead, it is more feasible to implement the functions of the slow clock with an RC circuit, which is lower in cost and possible to integrate into a chip circuit. RC oscillators, however, are less accurate. It has also been proposed to calibrate periodically the slow clock to the high frequency clock, either automatically, after a predetermined sleep time has elapsed, or whenever a wake-up of the device is triggered by an external event.

US Patents No. 6,029,061 (Kohlschmidt) and No. 6,453,181 (Challa et al) disclose various power saving schemes for mobile phones, wherein a slow, but inaccurate sleep mode clock is calibrated to a higher frequency, accurate reference clock at certain intervals. Specifically, US Patent No. 6,029,061 discloses a method where the fast clock signal and the slow clock signal is used to increment or decrement two registers during a specified time period, and thereafter a timing relationship is established between the slow and the fast clock signal.

However, the method and implementing apparatus disclosed in US Patent No. 6,029,061 is realized in the context of a mobile phone, and requires the use of relatively complicated control circuits, such as a digital processor, to obtain the calibration factor. Such complicated circuitry is relatively expensive, and is itself power-consuming.

Furthermore, the calibration process is relatively long, and requires multiple cycle times of the slow clock. This will not play a significant role in a mobile phone, which is expected to be switched on relatively often, and is also expected to be recharged regularly. However, this method is relatively expensive and inefficient if it needs to be realised in a cheap and low-power device, which is expected to run for a long time without external wake-ups, and where the majority of the automatically initiated wake-up times are only used for performing the calibration of the slow clock source.

A similarly complicated power saving scheme is disclosed in US Patent No. 6,453,181. This known method provides a very accurate calibration of the slow clock, but requires extensive calculating and controlling functions, the implementation of which is not feasible in simple and cheap wireless devices.

## SUMMARY OF THE INVENTION

In an embodiment of the present invention, there is provided a method for determining a calibration parameter, where the calibration parameter is used to compensate the variations of a low accuracy clock signal compared to a high accuracy clock signal. The method calls for:

- counting the number of cycles of said high accuracy clock signal during a single cycle of the low accuracy clock signal, and obtaining a first number being equal to the counted number of cycles,
- successively performing multiple summing operations with the first number, until the sum of the first numbers reaches a first predetermined value, and

- counting the number of summing operations, the calibration parameter being proportional to the number of summing operations.

In another embodiment of the present invention, there is provided a circuit assembly for providing a calibrated clock signal in a sleep mode, using a high accuracy clock and a low accuracy clock which is periodically calibrated to the high accuracy clock when the high accuracy clock is in a wake-up mode. The circuit assembly includes a high accuracy clock source, a low accuracy clock source, and a calibration circuit for providing a calibration parameter, where the calibration parameter is used to compensate the variations of the frequency of the low accuracy clock signal compared to a high accuracy clock signal. The circuit assembly further includes a frequency calibration circuit for providing a calibrated clock signal from the low accuracy clock signal and the calibration parameter. The calibration circuit includes a first register for counting the number of clock cycles of the high accuracy clock during a clock cycle of the low accuracy clock, and for obtaining a first number. The calibration circuit further includes an accumulator for performing successive summing operations of the first number obtained from the first register, and a second register for counting the number of summing operations performed by the second register and obtaining a second number. The circuit assembly also includes a control circuit. The control circuit controls the counting operations of the first and second registers, and the summing operations of the accumulator. The control circuit also monitors the contents of the accumulator and indicates when the content of the accumulator reaches a predetermined value, and outputs the second number from the second register as the calibration parameter when the content of said accumulator reaches the predetermined value.

The disclosed method and circuit is capable of obtaining the calibration factor within a relatively short time and does not require sophisticated circuits, such as a number divider circuit. The calibration factor is obtained as an integer number, and may be fed directly into a frequency divider circuit.

## BRIEF DESCRIPTION OF DRAWINGS

The invention will be now described with reference to the enclosed drawings, where:

Fig. 1    is a functional block diagram illustrating one embodiment of a wake-up type circuit according to the present invention, providing a calibrated frequency output based on a periodically calibrated low accuracy clock,

Fig. 2    is a functional block diagram illustrating one embodiment of the calibration factor calculator circuit of the circuit assembly shown in Fig. 1.

## DETAILED DESCRIPTION OF THE INVENTION

The present invention is directed toward a method and circuit for determining a calibration factor between a fast, high accuracy clock signal and a slow, low accuracy clock signal, which can be realised with a minimum number of electronic units, and which obtains the calibration factor in a very short time, thus minimising power consumption of the circuit. Such a calibration circuit also makes it possible to take into account the process tolerances of the various circuit elements, so the complete calibration circuit may be integrated on a single chip, if necessary.

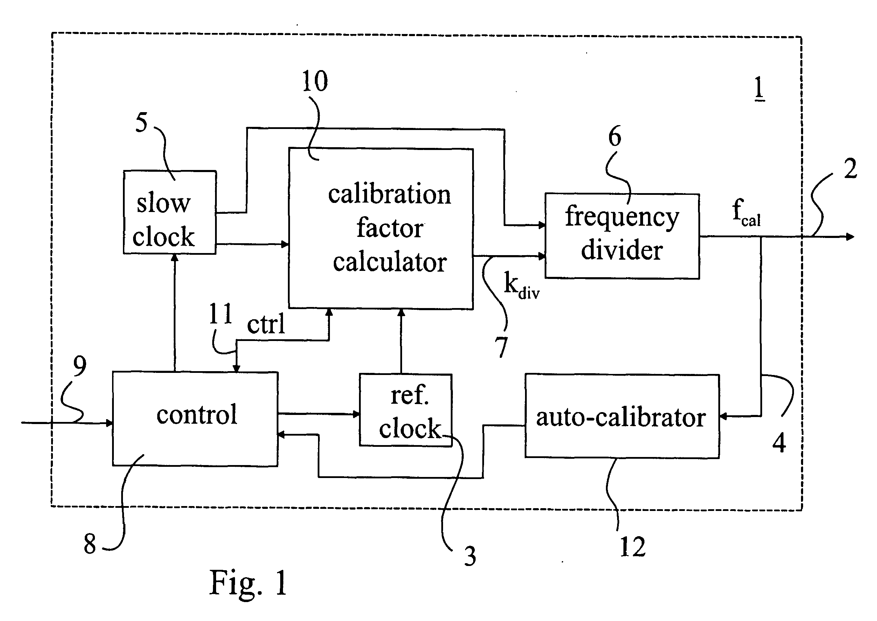

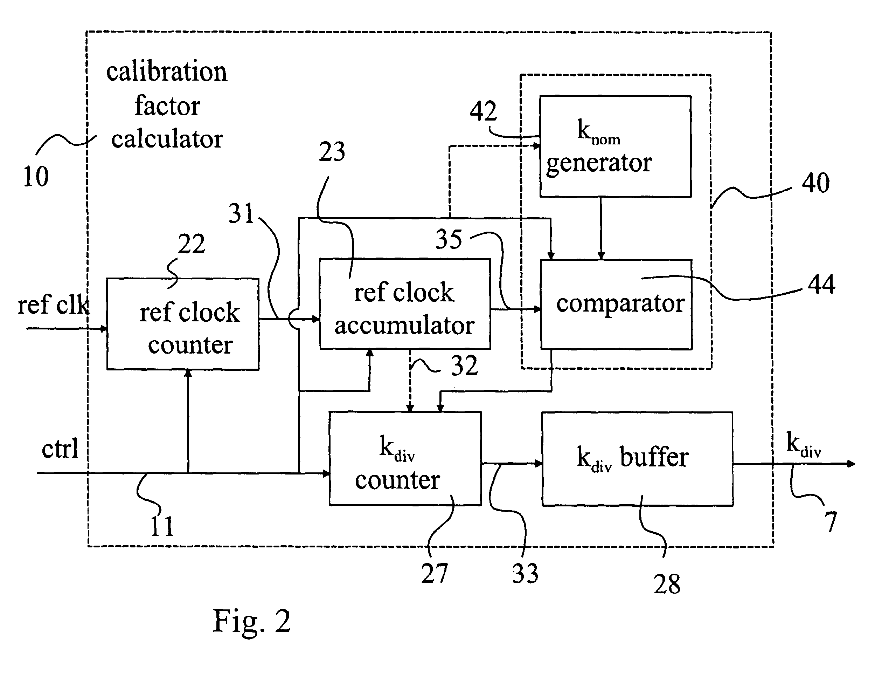

Referring now to Figs. 1 and 2, there is shown an embodiment of the circuit assembly in accordance with the invention, in the form of a wake-up circuit 1, which may form part of an external device (not illustrated), such as a radio transmitter-receiver unit. The wake-up circuit 1 is capable of providing a calibrated frequency during certain modes of operation, typically when the external device or at least the wake-up circuit 1 itself is in a low power sleep mode. In this sleep mode, it is still necessary to maintain a relatively accurate time base, for example for a receiver unit, or for an auto-calibrator circuit 12. For this purpose, the wake-up circuit provides a calibrated frequency $f_{cal}$, delivered at an output line 2 or to the internal line 4 providing the input of the auto-calibrator circuit 12. This latter forms a separate circuitry within the wake up-circuit 1, which periodically tunes the calibrated frequency $f_{cal}$ to a nominal output frequency $f_{nom}$, as will be explained in more detail below. The nominal output frequency $f_{nom}$ may be considered as a nominal value of a sleep mode frequency of the wake-up circuit 1, because the wake-up circuit 1 generates the calibrated frequency $f_{cal}$ at its output terminal when it is in either the sleep mode or a passive mode. The invention concerns a method and circuit for calibrating the calibrated frequency $f_{cal}$ with relatively few components and in a relatively short time.

The wake-up circuit 1 includes a reference clock source 3, which, in one embodiment, is a crystal oscillator. The reference clock source 3 provides a high accuracy clock that has a stable frequency and needs no calibration on its own. The high accuracy clock frequency $f_{ref}$ of the reference clock source 3 is used to calibrate the slow clock source 5, which is a low accuracy clock. This means that the output frequency $f_{slow}$ of the slow clock may vary due to various factors, such as temperature or process tolerances, and such variations need to be compensated in order to ensure proper functioning of the external device which relies on the slow clock signal. The slow clock source 5 in one embodiment, is realized as an RC oscillator.

The wake-up circuit 1 has a first mode (wake-up mode or active mode), wherein its reference clock source 3 and substantially all its component circuits are active. The wake-up circuit 1 also has a second mode (sleep mode or passive mode), in which it is partially shut off, particularly its power-consuming reference clock source 3. In the sleep mode, substantially only the slow clock source 5 is active, supplying a slow clock signal having the frequency $f_{slow}$, which, for example, may be approximately 50 kHz. The output frequency of the slow clock source 5 is fed into a frequency divider circuit 6, which divides the input frequency $f_{slow}$ with a division factor $k_{div}$, and thereby produces an output frequency $f_{cal}$. The frequency divider 6 is of a type that has no fixed frequency division ratio, but performs the frequency division according to a division factor $k_{div}$, having an integer value and being received from an input line 7, which may be a 8-bit parallel bus. For example, such frequency divider circuits are known to those of ordinary skill in the art, and need not be explained in more detail.

As mentioned above, the slow clock frequency $f_{slow}$ may vary. Therefore, in the present invention, the division factor $k_{div}$, is varied in order to obtain a more or less stable and calibrated output frequency $f_{cal}$ on the output 2 or on the internal line 4. For this purpose, the wake-up circuit 1 relies on its high accuracy reference clock source 3 for periodically checking the frequency of its low accuracy slow clock source 5, when the reference clock source 3 is in an active mode, i. e. when the reference clock source 3 is switched on.

The wake-up circuit 1 has a calibration circuit 10, which generates a calibration parameter. In the present embodiment, the calibration parameter is the division factor $k_{div}$, which may be fed directly to the frequency divider circuit 6. Since the value of the division factor $k_{div}$ is obtained by indirectly measuring the actual ratio between frequency $f_{slow}$ of the slow clock and the frequency $f_{ref}$ of the reference clock, the value of the division factor $k_{div}$ reflects this ratio, and therefore the division factor $k_{div}$ is suitable for calibrating the output frequency $f_{cal}$ of the wake-up circuit 1.

The wake-up circuit 1 shown in Fig. 1 further comprises an auto calibrator circuit 12. The auto calibrator circuit 12 itself also requires a nominal frequency $f_{nom}$, which can be used as a reliable time base of the auto calibrator circuit 12, acting as the "alarm clock" of the wake-up circuit. In the shown embodiment, the calibrated output frequency $f_{cal}$ of the wake-up circuit 1 is also tuned to this nominal frequency $f_{nom}$. More precisely, the calibration circuit 10 seeks to adjust the value of the division factor $k_{div}$ so that the relation $f_{nom} = f_{cal}$ is fulfilled.

The different units of the wake-up circuit 1 are controlled by a control circuit 8. This may be embodied by a digital processor, but more preferably it is a simple state machine-type circuit, where the few simple controlling functions of the control circuit 8, such as monitoring the states of, and the enabling, halting or resetting the other circuits are hardware implemented. As it will be apparent for a person skilled in the art, the control functions of the wake-up circuit 1 may be realized with a few logic gates.

As mentioned above, the calibrated output frequency $f_{cal}$ is obtained by dividing a slow clock frequency $f_{slow}$. with the division factor $k_{div}$. Accordingly, the nominal frequency $f_{nom}$ may be expressed as follows:

$$f_{nom} = f_{cal} = \frac{f_{slow}}{k_{div}} \quad (I)$$

where $k_{div} = k_{div}(f_{low}, f_{ref})$, i. e. the division factor $k_{div}$ is a function of the proportion between the (constant) reference frequency $f_{ref}$ and the (variable) slow clock frequency $f_{slow}$, because the calibration of the nominal frequency $f_{nom}$ relative to the slow clock frequency $f_{slow}$ is based on the reference frequency $f_{ref}$, as mentioned above.

Let us assume that the reference frequency $f_{ref}$ is used for obtaining the nominal frequency $f_{nom}$ directly. Accordingly,

$$f_{nom} \simeq \frac{f_{ref}}{k_{nom}} \quad (II)$$

where $k_{nom}$ is a constant, keeping in mind that both the nominal frequency $f_{nom}$ and the reference frequency $f_{ref}$ are considered as constants. Combining equations I and II and eliminating $f_{nom}$, we obtain

$$\frac{k_{div}}{f_{slow}} = \frac{k_{nom}}{f_{ref}} = T \quad (III)$$

where T is a time value, with the following physical meaning: $k_{nom}$ number of cycles of a frequency $f_{ref}$ will have the duration of T. Similarly, it also holds that $k_{div}$ number of cycles of a frequency $f_{slow}$ will have the duration of T, as it is apparent from the equation III. This may be again reformulated as the following statement: A frequency $f_{slow}$ will have $k_{div}$ number of cycles during a time interval T.

Using a similar approach, starting from equation (III), we may write

$$k_{div} = \frac{f_{slow}}{f_{ref}} k_{nom} \quad (IV)$$

Further, introducing the variable factor m as the factor between the slow clock frequency $f_{slow}$ and the reference frequency $f_{ref}$, expressed as $f_{slow} = m\, f_{ref}$, we obtain

$$\frac{f_{slow}}{f_{ref}} = \frac{1}{m} \quad (V)$$

Substituting Eq. IV into Eq. V, we obtain

$$k_{div} = \frac{k_{nom}}{m} \quad (IV)$$

Eq. V may be also formulated as

$$\frac{m}{f_{ref}} = \frac{1}{f_{slow}} = T_{slow} \quad (V)$$

which, as explained above, has the following concrete physical meaning: $T_{slow}$ is the cycle time of the slow clock frequency $f_{slow}$, i. e. during a time interval $T_{slow}$ the slow clock frequency $f_{slow}$ makes a single cycle. Similarly, during the time $T_{slow}$ the reference frequency $f_{ref}$ will have m number of cycles. Rearranging Eq. IV, we obtain

$$k_{div} \cdot m = k_{nom} \quad (VI)$$

Eq. VI is the basis for obtaining the frequency division factor $k_{div}$ in a very simple manner, with the help of the measured value of m and the calculated value of $k_{nom}$. Namely, Eq. VI may be considered as stating: the value m must be repeated $k_{div}$ times for arriving at the value $k_{nom}$. An embodiment of the method and apparatus of the invention is based on the practical implementation of this recognition.

A possible embodiment of the calibration circuit 10 is shown in Fig. 2, showing the functional units of the calibration circuit 10. There is a reference clock counter 22, which is substantially an incremental register, an accumulator circuit 23 in combination with a comparator 40, and a divisional factor counter 27, the latter again realised as a simple incremental register. In the embodiment shown in Fig. 2, the calibration circuit 10 also includes a divisional factor buffer 28, which is also a simple register.

The main function of the reference clock counter 22 is counting the number of clock cycles of the reference clock source 3 during a single clock cycle of the slow clock source 5. In this manner the reference clock counter 22 obtains the number $m = f_{ref}/f_{slow}$, as explained above. In fact, since the reference clock counter 22 only counts integers, the $m_{int} = int(m)$ value is found by the reference clock counter 22.

Under the control of the control circuit 8, the accumulator 23 receives at its input the value of the reference clock counter 22 through line 31, where line 31 may be a multi-bit bus. The accumulator 23 performs successive summing operations with the value received on its input, in the sense that when enabled, the accumulator 23 successively adds the input value to the actually stored value in the accumulator 23, at every clock pulse. Such an accumulator may be realised in a simple manner as the combination of a register and an adder, where the output of the register is fed back to an input of the adder, while the other input of the adder is considered as the input of the accumulator.

The divisional factor counter 27 in the calibration circuit 10 is another incremental register. It may be connected to the accumulator 23 through a line 32, but this latter may be also omitted. The divisional factor counter 27 counts the number of summing operations performed by the accumulator 23, i. e. when the divisional factor counter 27 is enabled, at every clock pulse when the accumulator 23 performs a summing operation, the divisional factor counter 27 is incremented with the value of one. As mentioned above, it is not strictly necessary to connect the accumulator 23 and the divisional factor counter 27, but the control circuit 8 may simply issue a common enabling signal and a common clock to the accumulator 23 and the divisional factor counter 27.

The control circuit 8 is designed to monitor the content of the accumulator 23, and to indicate when the content of the accumulator 23 reaches a predetermined value. For this purpose, the calibration circuit 10 comprises the comparator 40, which receives one of its inputs from the accumulator 23 through line 35. In the shown embodiment, the comparator circuit 40 is designed to compare an integer value received from the accumulator 23 with the integer value $int(k_{nom})$, where $k_{nom} = f_{ref}/f_{nom}$, as defined by Eq. II above. In the following discussion, we will consider the $k_{nom} = int(k_{nom})$ simplification, taking into account that the high accuracy clock frequency $f_{ref}$ is normally several magnitudes higher than the desired nominal output frequency $f_{nom}$, so the neglecting of the fractional value of $k_{nom}$ involves a small error only. The comparator circuit 40 may be designed to compare a hardware implemented, fixed $k_{nom}$ value with the contents of the accumulator 23, such as shown in Fig. 2, where the $k_{nom}$ generator 42 and the comparator 44 together constitutes the comparator circuit 40. In this case the $k_{nom}$ generator 42 is wired to output an integer, fixed $k_{nom}$ value to the comparator 44 through the line 36. Instead of a general-purpose comparator (i. e. which is capable of comparing two arbitrary inputs) it is also possible to design the comparator 44 to compare only a wired, fixed $k_{nom}$ value with a single arbitrary input value. In this case the fixed $k_{nom}$ value is not fed to the comparator 44 from an external source, and the comparator 44 is itself designed for performing the comparison between an arbitrary input value and the predetermined fixed value. This solution may be designed with a few gates only, and it is preferable where the reference frequency $f_{ref}$ of the high accuracy clock is known exactly, and the nominal output frequency $f_{nom}$ need not be varied. For example, the high accuracy clock may run on a frequency of 2.5 MHz, and the desired nominal output frequency $f_{nom}$ may be 2 kHz, resulting in a $k_{nom}$ value of 1250.

Alternatively, the desired nominal output frequency $f_{nom}$ may vary, if a variable value of $k_{nom}$ is fed to the comparator 40 either directly from the control circuit 8, or from the $k_{nom}$ generator 42, by controlling a $k_{nom}$ value generating algorithm within the $k_{nom}$ generator 42.

As mentioned above, the calibration circuit 10 also comprises a divisional factor buffer 28. Under the control of the control circuit 8, the divisional factor counter 27 may latch its content to the divisional factor buffer 28 through line 33. This latter maintains the latched value until resetting, or until another value is received from the divisional factor counter 27. The content of the divisional factor buffer 28 are output on line 7.

At the end of a calibration procedure explained further below, it is the content of the divisional factor buffer 28 which represents the sought value $k_{div}$, which may be output as the calibration parameter from the calibration circuit 10.

The circuit works as follows: Upon start-up of the circuit or after a reset, both the reference clock source 3 and the slow clock source 5 are turned on. The calibration process may allow some time for the clocks to reach their stable frequency. During periodic calibrations, when the wake-up circuit returns to the active mode from a sleep mode, the slow clock source 5 is continuously switched on, since it is the source of the output frequency $f_{cal}$, and therefore needs no settling time. For example, the reference frequency $f_{ref}$ may be 2.5 MHz, while the slow clock frequency $f_{slow}$ may settle for a value between 20-100 kHz, depending on process tolerances and ambient temperature. In the meanwhile, the reference clock counter 22, the accumulator 23 and the divisional factor counter 27 are reset to zero.

Under the control of the control circuit 8, which monitors the clock pulses from both the reference clock source 3 and the slow clock source 5, the reference clock counter 22 starts to count the clock pulses of the reference clock source 3, simultaneously with a clock pulse of the slow clock source 5, and continues the count until the next clock pulse of the slow clock source 5. In practice, this is simply realized by resetting the reference clock counter 22 to zero upon a slow clock pulse and clocking the reference clock counter 22 with the clock pulses of the reference clock source 3. Since the reference clock counter 22 is an incremental register, it will count the number of cycles of the high accuracy clock signal during a single cycle of the low accuracy clock signal. The counting of the reference clock pulses stops upon the next clock pulse of the slow clock. In this manner, between two clock pulses of the slow clock source 5 the reference clock counter 22 will obtain the variable factor m as defined by equations II and V. More properly, it will obtain the integer value $m_{int}$ = int $(f_{ref}/f_{slow})$. For the following discussion, we will use the $m = m_{int}$ approximation.

In the next step, simultaneously as the reference clock counter 22 stops the counting, its content, i. e. the variable factor m is fed through line 31 to the accumulator 23. For example, if the momentary value of $f_{slow}$ is 50 kHz, the reference clock counter 22 will increment until m = 50. This m value is then maintained in the reference clock counter 22, until reset to zero by the control circuit 8 in the next calibration process.

Having stopped the counting of the reference clock counter 22, the control circuit 8 now enables the operation of the accumulator 23, which is also clocked with the reference frequency $f_{ref}$. At every clock pulse of the reference clock source 3, the content of the accumulator 23 is increased with the value of m. At the same time, the content of the accumulator 23 is fed to the comparator circuit 40, which indicates when the content of the accumulator 23 reaches or surpasses the $k_{nom}$ input value of the comparator, either towards the control circuit 8 or towards the divisional factor counter 27. For example, assuming $k_{nom}$ = 1250 and m = 50, after 1250 : 50 = 25 cycles of the reference clock source 3, the accumulator 23 will reach the value 1250.

Simultaneously with the accumulator 23, the control circuit 8 will also enable the operation of the divisional factor counter 27, which is also clocked to the reference clock source 3. The divisional factor counter 27 will increment with the value of one at every clock pulse. Having reached the predetermined value of $k_{nom}$, upon the signal from the comparator 40, the control circuit 8 will stop the counting of the divisional factor counter 27, which has in this manner calculated the number of summing operations performed by the accumulator 23, since the two units were enabled and subsequently stopped simultaneously. Accordingly, the divisional factor counter 27 has in fact calculated the result of the division $k_{nom}$ / m = $k_{div}$, according to Eq. IV. More precisely, the divisional factor counter 27 now contains the integer value $k_{div}$ = int $(k_{nom}/m)$.

As is clear from the description above, the divisional factor counter 27 has, in this manner, directly obtained the desired calibration parameter for calibrating the slow clock frequency $f_{slow}$, e.g. the division factor $k_{div}$. This is now fed to the divisional factor buffer 28 under the control of the control circuit 8, where it is maintained for output to the frequency divider 6 until a new calibration procedure is performed and a new division factor $k_{div}$ is obtained.

As is apparent to one of ordinary skill in the art, the calibration parameter may be obtained during less than two complete clock cycles of the slow clock source 5. Thereafter, the control circuit may switch off the power-consuming reference clock source 3, and also many parts of the calibration circuit 10, with the exception of the divisional factor buffer 28. The slow clock source 5, and possibly the auto-calibration circuit 12 remain active.

The wake-up circuit 1 explained with reference to Figs. 1 and 2 has a very simple structure, which may be realized with a few standard logic building blocks, which are easily integrated in a single chip.

It must be noted that maximum error of the proposed method of frequency calibration is less than 5%, when operating in the orders of magnitude as described above. This error results mainly from the truncation errors, which are due to the use of integers for the values of $k_{nom}$, m and $k_{div}$. The average truncation error may be partly compensated by modifying the value of $k_{nom}$ slightly. For example, in the case of the specific values discussed above, instead of setting $k_{nom}$ = 1250, better results can be obtained by increasing the value to $k_{nom}$ = 1254 or $k_{nom}$ = 1255. This increase will take into account some of the losses made during the truncations, and also helps to offset asymmetries of the frequency error of the slow clock.

A new calibration procedure may be initiated in various situations. For example, an external signal, such as the pressing of a button may initiate the calibration procedure through the input line 9 of the control circuit 8. Typically, beside such external factors, the wake-up circuit will automatically initiate a calibration of the slow clock frequency, to take into account frequency drifts caused by temperature changes or the like. For this purpose, the auto-calibrator circuit 12 of the wake-up circuit 1 will regularly initiate a calibration, for example every 30 seconds. The auto-calibrator circuit 12 may be considered as an independent control circuit, which keeps time with an internal register clocked by the calibrated frequency $f_{cal}$, and detects automatically when the predetermined sleep time has elapsed. Such auto-calibrator circuits are known per se, and need not be discussed in more detail.

The invention is not limited to the shown and disclosed embodiments, but other elements, improvements and variations are also within the scope of the invention. For example, it is clear for those skilled in the art that functions of the comparator 40 and the accumulator 23 can also be realized by loading the value of $k_{nom}$ to a register, and subtracting the value of m from the register, while monitoring when the register reaches zero, instead of accumulating the m values. Also, the disclosed controlling functions of the various circuits may be realized in a number of different ways, either by hardware or software, though the preferred realization is with hardware.

## Claims

1. A method for determining a calibration parameter ($K_{div}$), the calibration parameter being used to compensate the variations of a low accuracy clock signal compared to a high accuracy clock signal (ref), the method comprising the steps of:

   counting the number of cycles of said high accuracy clock signal during a single cycle of the low accuracy clock signal to obtain a first number (m) representing the number of cycles counted;

   performing successive summing operations (in 23, 44, 27) with the first number (m) until a sum of the first numbers reaches a first predetermined value ($K_{now}$); and

   counting the number of summing operations required to reach the first predetermined value in order to determine the calibration parameter, where the calibration factor is proportional to the number of summing operations.

2. The method of claim 1, in which said first predetermined value is a ratio between the frequency of the high accuracy clock and a nominal value of a sleep mode frequency.

3. The method of claim 1 or claim 2, in which the calibration parameter is equal to the number of summing operations.

4. The method of any preceding claim, in which the summing operation is an addition, where the first number is initially added to a zero.

5. The method of any one of claims 1 to 3, in which the summing operation is a subtraction, where the first number is successively subtracted from the first predetermined value, until the resulting number reaches a second predetermined value.

6. The method of claim 5, in which said first predetermined value is a ratio between the frequency of the high accuracy clock and a nominal value of a sleep mode frequency, and the second predetermined value is zero.

7. A circuit assembly for providing a calibrated clock signal in a sleep mode, using a high accuracy clock and a low accuracy clock which is periodically calibrated to the high accuracy clock when the high accuracy clock is in an active mode, the circuit comprising:

   a high accuracy clock source;
   a low accuracy clock source;
   a calibration circuit for providing a calibration parameter, where the calibration parameter is used to compensate the variations of the frequency of the low accuracy clock signal compared with a high accuracy clock signal;
   a frequency calibration circuit for providing a calibrated clock signal from the low accuracy clock signal and the calibration parameter; and where the calibration circuit comprises:

   a first register for counting the number of clock cycles of the high accuracy clock during a clock cycle of the low accuracy clock, and for obtaining a first number,

an accumulator for performing successive summing operations of the first number obtained from the first register,

a second register for counting the number of summing operations performed by the second register and obtaining a second number, and

a control circuit configured to control the counting operations of the first and second registers, and the summing operations of the accumulator, monitor the contents of the accumulator and indicating when the content of the accumulator reaches a predetermined value, and output the second number from the second register as the calibration parameter when the content of said accumulator reaches said predetermined value.

8. The circuit assembly of claim 7, in which the frequency calibration circuit further comprises a frequency divider for dividing the frequency of the low accuracy clock with the calibration parameter.

9. The circuit assembly of claim 7 or claim 8, further comprising a third register for temporarily storing an actual value of the calibration parameter.

10. The circuit assembly of claim 9, in which said third register stores said value of the calibration parameter between calibration procedures initiated by a second control circuit.

11. The circuit assembly of claim 10, in which said second control circuit periodically initiates a calibration procedure of the low accuracy clock signal.

12. The circuit assembly of any one of claims 7 to 11, the circuit assembly further including a comparator for comparing the content of said accumulator with said predetermined value.

13. The circuit assembly of claim 12, in which said predetermined value is hardwired into the comparator.

14. The circuit assembly of claim 12, in which said predetermined value is fed to an input of the comparator from a circuit external to the comparator.

15. The circuit assembly of any of claims 7 to 14, in which functions of said control circuit are hardware implemented.

16. The circuit assembly of claim 15, in which said functions of said control circuit comprise the resetting, enabling and halting of the controlled circuits, and detecting predetermined states of the controlled circuits.

17. A circuit for determining a calibration parameter, the calibration parameter being used to compensate the variations of a low accuracy clock signal compared to a high accuracy clock signal, the circuit comprising:

means for counting the number of cycles of said high accuracy clock signal during a single cycle of the low accuracy clock signal to obtain a first number representing the number of cycles counted;

means for performing successive summing operations with the first number until a sum of the first numbers reaches a first predetermined value; and

means for counting the number of summing operations required to reach the first predetermined value in order to determine the calibration parameter, where the calibration factor is proportional to the number of summing operations.

18. The circuit of claim 17, wherein the means for performing successive summing operations includes addition means for initially adding the first number to a zero value.

19. The circuit of claim 17, wherein the means for performing successive summing operations further comprises subtraction means for successively subtracting the first number from the first predetermined value to produce a resulting number until the resulting number reaches a second predetermined value.

**Patentansprüche**

1. Verfahren zum Ermitteln eines Kalibrierparameters ($K_{div}$), wobei der Kalibrierparameter verwendet wird, um die Variationen eines Taktsignals geringer Genauigkeit verglichen mit einem Taktsignal (ref) hoher Genauigkeit zu kompensieren, wobei das Verfahren die Schritte umfasst:

Zählen der Anzahl an Taktzyklen des Taktsignals mit hoher Genauigkeit während eines einzelnen Taktzyklus des Taktsignals mit geringer Genauigkeit, um eine erste Zahl (m) zu erhalten, die die Anzahl an gezählten Taktzyklen angibt;

Durchführen von aufeinander folgenden Summieroperationen (in 23, 24, 27) mit der ersten Zahl (m), bis eine Summe der ersten Zahlen einen ersten vorbestimmten Wert ($K_{nom}$) erreicht; und

Zählen der Anzahl an Summieroperationen, die benötigt werden, um den ersten vorbestimmten Wert zu erreichen, um den Kalibrierparameter zu ermitteln, wobei der Kalibrierfaktor proportional zu der Anzahl an Summieroperationen ist.

**EP 1 585 223 B1**

**2.** Verfahren nach Anspruch 1, bei dem der erste vorbestimmte Wert ein Verhältnis zwischen der Frequenz des Takts hoher Genauigkeit und eines Sollwerts einer Frequenz für eine Ruhebetriebsart ist.

**3.** Verfahren nach Anspruch 1 oder 2, bei dem der Kalibrierparameter der Anzahl an Summieroperationen entspricht.

**4.** Verfahren nach einem vorherigen Anspruch, bei dem die Summieroperation eine Addition ist, wobei die erste Zahl anfänglich zu Null hinzu addiert wird.

**5.** Verfahren nach einem der Ansprüche 1 bis 3, bei dem die Summieroperation eine Subtraktion ist, wobei die erste Zahl sukzessive von dem ersten vorbestimmten Wert subtrahiert wird, bis die resultierende Zahl einen zweiten vorbestimmten Wert erreicht.

**6.** Verfahren nach Anspruch 5, bei dem der erste vorbestimmte Wert ein Verhältnis zwischen der Frequenz des Takts hoher Genauigkeit und eines Sollwerts einer Frequenz für eine Ruhebetriebsart ist und der zweite vorbestimmte Wert Null ist.

**7.** Schaltkreisanordnung zum Bereitstellen eines kalibrierten Taktsignals in einer Ruhebetriebsart unter Verwendung eines Takts hoher Genauigkeit und eines Takts geringer Genauigkeit, der periodisch auf den Takt hoher Genauigkeit kalibriert wird, wenn sich der Takt hoher Genauigkeit in einer aktiven Betriebsart befindet, wobei der Schaltkreis umfasst:

eine Taktquelle hoher Genauigkeit;
eine Taktquelle geringer Genauigkeit;
einen Kalibrierschaltkreis zum Bereitstellen eines Kalibrierparameters, wobei der Kalibrierparameter verwendet wird, um die Variationen der Frequenz des Taktsignals geringer Genauigkeit verglichen mit einem Taktsignal hoher Genauigkeit zu kompensieren;
einen Frequenzkalibrierschaltkreis zum Bereitstellen eines kalibrierten Taktsignals aus dem Taktsignal geringer Genauigkeit und dem Kalibrierparameter; und
wobei der Kalibrierschaltkreis umfasst:

ein erstes Register zum Zählen der Anzahl an Taktzyklen des Takts hoher Genauigkeit während eines Taktzyklus des Takts geringer Genauigkeit und zum Erhalten einer ersten Zahl;
einen Speicher zum Durchführen von aufeinander folgenden Summieroperationen der ersten von dem ersten Register erhaltenen Zahl,
ein zweites Register zum Zählen der Anzahl an Summieroperationen, die von dem zweiten Register durchgeführt werden, und Erhalten einer zweiten Zahl, und
einen Steuerschaltkreis, der konfiguriert ist, die Zähloperationen der ersten und zweiten Register und die Summieroperationen des Speichers zu steuern, die Inhalte des Speichers zu überwachen und anzugeben, wenn der Inhalt des Speichers einen vorbestimmten Wert erreicht, und die zweite Zahl von dem zweiten Register als den Kalibrierparameter auszugeben, wenn der Inhalt des Speichers den vorbestimmten Wert erreicht.

**8.** Schaltkreisanordnung nach Anspruch 7, bei dem der Frequenzkalibrierschaltkreis ferner einen Frequenzteiler zum Teilen der Frequenz des Takts geringer Genauigkeit durch den Kalibrierparameter umfasst.

**9.** Schaltkreisanordnung nach Anspruch 7 oder Anspruch 8, ferner mit einem dritten Register zum temporären Speichern eines aktuellen Werts des Kalibrierparameters.

**10.** Schaltkreisanordnung nach Anspruch 9, bei dem das dritte Register den Wert des Kalibrierparameters zwischen von einem zweiten Steuerschaltkreis initiierten Kalibrierprozeduren speichert.

**11.** Schaltkreisanordnung nach Anspruch 10, bei der der zweite Steuerschaltkreis periodisch eine Kalibrierprozedur des Taktsignals geringer Genauigkeit initiiert.

**12.** Schaltkreisanordnung nach einem der Ansprüche 7 bis 11, wobei die Schaltkreisanordnung ferner einen Komparator zum Vergleichen des Inhalts des Speichers mit dem vorbestimmten Wert aufweist.

**13.** Schaltkreisanordnung nach Anspruch 12, bei dem der vorbestimmte Wert in dem Komparator festverdrahtet ist.

**14.** Schaltkreisanordnung nach Anspruch 12, bei dem der vorbestimmte Wert ausgehend von einem Schaltkreis außerhalb des Komparators einem Eingang des Komparators zugeführt wird.

**15.** Schaltkreisanordnung nach einem der Ansprüche 7 bis 14, bei dem Funktionen des Steuerschaltkreises hardware-implementiert sind.

**16.** Schaltkreisanordnung nach Anspruch 15, bei dem die Funktionen des Steuerschaltkreises das Rücksetzen, Freigeben und Anhalten der gesteuerten Schaltkreise und Detektieren von vorbestimmten Zuständen der gesteuerten Schaltkreise umfassen.

**17.** Schaltkreis zum Ermitteln eines Kalibrierparameters, wobei der Kalibrierparameter verwendet wird, um die Variationen eines Taktsignals geringer Genauigkeit verglichen mit einem Taktsignal hoher Genauigkeit zu kompensieren, wobei der Schaltkreis umfasst:

eine Einrichtung zum Zählen der Anzahl an Zyklen des Taktsignals hoher Genauigkeit während eines einzelnen Zyklus des Taktsignals geringer Genauigkeit, um eine erste Zahl zu erhalten, die die Anzahl an gezählten Zyklen angibt; eine Einrichtung zum Durchführen von aufeinander folgenden Summieroperationen mit der ersten Zahl, bis eine Summe der ersten Zahlen einen ersten vorbestimmten Wert erreicht; und eine Einrichtung zum Zählen der Anzahl an Summieroperationen, die benötigt werden, um den ersten vorbestimmten Wert zu erreichen, um den Kalibrierparameter zu ermitteln, wobei der Kalibrierfaktor proportional zu der Anzahl an Summieroperationen ist.

**18.** Schaltkreis nach Anspruch 17, bei dem die Einrichtung zum Durchführen von aufeinander folgenden Summieroperationen eine Addiereinrichtung aufweist, um anfänglich die erste Zahl zu einem Wert von Null hinzu zu addieren.

**19.** Schaltkreis nach Anspruch 17, bei dem die Einrichtung zum Durchführen von aufeinander folgenden Summieroperationen ferner eine Subtraktionseinrichtung umfasst, um sukzessive die erste Zahl von dem ersten vorbestimmten Wert abzuziehen, um eine resultierende Zahl zu erzeugen, bis die resultierende Zahl einen zweiten vorbestimmten Wert erreicht.

**Revendications**

**1.** Procédé permettant de déterminer un paramètre de calibration ($k_{div}$), le paramètre de calibration étant utilisé pour compenser les variations d'un signal d'horloge de faible précision par rapport à un signal d'horloge de haute précision (ref), le procédé comprenant les étapes consistant à :

compter le nombre de cycles dudit signal d'horloge de haute précision au cours d'un cycle unique du signal d'horloge de faible précision pour obtenir un premier nombre (m) représentant le nombre de cycles comptés ; exécuter des opérations d'addition successives (23, 44, 27), avec le premier nombre (m) jusqu'à ce qu'une somme des premiers nombres atteigne une première valeur prédéterminée ($k_{nom}$) ; et

compter le nombre d'opérations d'addition requises pour atteindre la première valeur prédéterminée afin de déterminer le paramètre de calibration, le facteur de calibration étant proportionnel au nombre d'opérations d'addition.

**2.** Procédé selon la revendication 1, dans lequel ladite première valeur prédéterminée constitue un rapport entre la fréquence de l'horloge de haute précision et une valeur nominale d'une fréquence de mode de veille.

**3.** Procédé selon la revendication 1 ou 2, dans lequel le paramètre de calibration est égal au nombre d'opérations d'addition.

**4.** Procédé selon l'une quelconque des revendications précédentes, dans lequel l'opération d'addition est une addition, le premier nombre étant initialement ajouté à un zéro.

**5.** Procédé selon l'une quelconque des revendications 1 à 3, dans lequel l'opération d'addition est une soustraction, le premier nombre étant successivement soustrait de la première valeur prédéterminée, jusqu'à ce que le nombre obtenu atteigne une deuxième valeur prédéterminée.

**6.** Procédé selon la revendication 5, dans lequel ladite première valeur prédéterminée constitue un rapport entre la fréquence de l'horloge de haute précision et une valeur nominale d'une fréquence de mode de veille, et la deuxième valeur prédéterminée est zéro.

**7.** Ensemble de circuits permettant de fournir un signal d'horloge calibré dans un mode de veille, en utilisant une horloge de haute précision et une horloge de faible précision qui est périodiquement calibrée par rapport à l'horloge de haute précision lorsque l'horloge de haute précision se trouve dans un mode actif, le circuit comprenant :

une source d'horloge de haute précision ; une source d'horloge de faible précision ; un circuit de calibration permettant de fournir un paramètre de calibration, le paramètre de calibration étant utilisé pour compenser les variations de la fréquence du signal d'horloge de faible précision par rapport à un signal d'horloge de haute précision ; un circuit de calibration de fréquence permettant de fournir un signal d'horloge calibré à partir du signal d'horloge de faible précision et du paramètre de calibration ; et dans lequel le circuit de calibration comprend :

un premier registre permettant de compter le nombre de cycles d'horloge de l'horloge de haute précision au cours d'un cycle d'horloge de l'horloge de faible précision, et d'obtenir un premier nombre,

un accumulateur permettant d'exécuter des opérations d'addition successives du premier nombre obtenu à partir du premier registre,

un deuxième registre permettant de compter le nombre d'opérations d'addition exécutées par le deuxième registre et d'obtenir un deuxième nombre, et

un circuit de commande configuré pour commander les opérations de comptage des premier et deuxième registres, et les opérations d'addition de l'accumulateur, contrôler le contenu de l'accumulateur et indiquer le moment où le contenu de l'accumulateur atteint une valeur prédéterminée, et sortir le deuxième nombre du deuxième registre en tant que paramètre de calibration lorsque le contenu dudit accumulateur atteint ladite valeur prédéterminée.

8. Ensemble de circuits selon la revendication 7, dans lequel le circuit de calibration de fréquence comprend en outre un diviseur de fréquence permettant de diviser la fréquence de l'horloge de faible précision par le paramètre de calibration.

9. Ensemble de circuits selon la revendication 7 ou la revendication 8, comprenant en outre un troisième registre permettant de stocker provisoirement une valeur réelle du paramètre de calibration.

10. Ensemble de circuits selon la revendication 9, dans lequel ledit troisième registre stocke ladite valeur du paramètre de calibration entre les procédures de calibration initiées par un deuxième circuit de commande.

11. Ensemble de circuits selon la revendication 10, dans lequel ledit deuxième circuit de commande initie périodiquement une procédure de calibration du signal d'horloge de faible précision.

12. Ensemble de circuits selon l'une quelconque des revendications 7 à 11, l'ensemble de circuits comportant en outre un comparateur permettant de comparer le contenu dudit accumulateur à ladite valeur prédéterminée.

13. Ensemble de circuits selon la revendication 12, dans lequel ladite valeur prédéterminée est entrée dans le comparateur.

14. Ensemble de circuits selon la revendication 12, dans lequel ladite valeur prédéterminée est fournie à une entrée du comparateur à partir d'un circuit externe au comparateur.

15. Ensemble de circuits selon l'une quelconque des revendications 7 à 14, dans lequel les fonctions dudit circuit de commande sont mises en oeuvre de manière matérielle.

16. Ensemble de circuits selon la revendication 15, dans lequel lesdites fonctions dudit circuit de commande comprennent la remise à l'état initial, l'activation et l'arrêt des circuits de commande, et la détection des états prédéterminés des circuits commandés.

17. Circuit permettant de déterminer un paramètre de calibration, le paramètre de calibration étant utilisé pour compenser les variations d'un signal d'horloge de faible précision par rapport à un signal d'horloge de haute précision, le circuit comprenant :

des moyens permettant de compter le nombre de cycles dudit signal d'horloge de haute précision au cours d'un cycle unique du signal d'horloge de faible précision pour obtenir un premier nombre représentant le nombre de cycles comptés ;

des moyens permettant d'exécuter des opérations d'addition successives avec le premier nombre jusqu'à ce qu'une somme des premiers nombres atteigne une première valeur prédéterminée ; et

des moyens permettant de compter le nombre d'opérations d'addition requises pour atteindre la première valeur prédéterminée afin de déterminer le paramètre de calibration, le facteur de calibration étant proportionnel au nombre d'opérations d'addition.

18. Circuit selon la revendication 17, dans lequel les moyens permettant d'exécuter des opérations d'addition successives comportent des moyens d'addition permettant d'ajouter initialement le premier nombre à une valeur de zéro.

19. Circuit selon la revendication 17, dans lequel les moyens permettant d'exécuter les opérations d'addition successives comprennent en outre des moyens de soustraction permettant de soustraire successivement le premier nombre de la première valeur prédéterminée pour produire un nombre obtenu jusqu'à ce que le nombre obtenu atteigne une deuxième valeur prédéterminée.

Fig. 1

Fig. 2

EP 1 585 223 B1

**EP 1 585 223 B1**

**REFERENCES CITED IN THE DESCRIPTION**

**Patent documents cited in the description**

- US 6029061 A, Kohlschmidt

- US 6453181 B, Challa

14